# EUROPÄISCHE PATENTANMELDUNG

(11) **EP 1 720 241 A2**
(43) Veröffentlichungstag der Anmeldung: **08.11.2006**
(21) Anmeldenummer: 06006480.5
(22) Anmeldetag: 29.03.2006
(51) Int. Cl.: H02N 6/00

(54) **Photovoltaikgenerator mit Thermoschaltelement**

(30) Priorität: 18.04.2005 DE 102005017835
(71) Anmelder: Beck Energy GmbH, 97332 Volkach-Dimbach (DE)
(72) Erfinder: Neußner, Thomas, Dipl. Ing., 97509 Kolitzheim-Zeilitzheim (DE)

(57) **Zusammenfassung**

Der Photovoltaikgenerator weist einen Thermoschalter (13, 17, 25) auf, der beim Ansprechen eine Reduzierung der Leistung des Photovoltaikgenerators (1A, 1B, 1 C) bewirkt.

In einer bevorzugten Ausführungsform bildet eine Vielzahl von in Reihe geschalteten Photovoltaikzellen (3) gemeinsam ein Photovoltaikmodul (5). Am Ende der Reihe sind zwei elektrische Modul-Anschlusspole (7, 9) vorhanden. Der Thermoschalter (13) schließt beim Ansprechen die Modul-Anschlusspole (7, 9) kurz. Durch diese Maßnahme wird der Photovoltaikgenerator (1A) im Brandfall in einen für einen löschenden Feuerwehrmann ungefährlichen Betriebszustand überführt.

## Beschreibung

Die Erfindung bezieht sich auf einen Photovoltaikgenerator, im folgenden kurz Generator genannt. Dabei wird hier unter dem Begriff "Photovoltaikgenerator" jede Komponente, wie:
a) das einzelne Photovoltaikmodul oder
b) eine Zwischenanordnung, wie z.B. die Zusammenfügung mehrerer Photovoltaikmodule zu einem Photovoltaikstrang, oder
c) ein gesamtes System als komplette Photovoltaikanlage
verstanden, das geeignet ist, elektrischen Strom durch Umwandlung aus Sonnenenergie zu gewinnen.

Photovoltaikanlagen sind sattsam bekannt. Sie gewinnen, insbesondere in Ländern, die eine staatliche Förderung vorsehen, immer mehr an Bedeutung. Vorliegende Erfindung befasst sich weniger mit Großanlagen, die auf einem freien Feld aufgestellt werden, als vielmehr mit kleineren Anlagen im Bereich von mehreren kW elektrische Leistung, die auf Gebäudedächern montiert werden.

Die Erfindung beruht auf der Überlegung, dass auch Wohngebäude und Wirtschaftgebäude mit Photovoltaikanlagen nicht gegen Brand gefeit sind, und dass sie bei einem Brand in einen für den Feuerwehrmann ungefährlichen Zustand überführt werden sollten.

Photovoltaikanlagen umfassen in der Regel mehrere Photovoltaikmodule (im folgenden kurz Module genannt), die in Serie angeordnet und dabei zu einem Strang zusammengefasst sind. Mehrere dieser Stränge sind parallel zueinander angeordnet und bilden so eine Photovoltaikanlage. Zur Nutzung des gewonnenen Solarstroms ist parallel zu den Strängen ein Wechselrichter geschaltet, der den Gleichstrom in Wechselstrom umwandelt. Im Sinne obiger Definition des Begriffs "Photovoltaikgenerator" gehört der Wechselrichter nicht zum Photovoltaikgenerator selber. Ein einzelnes Photovoltaikmodul umfasst eine Vielzahl von in Serie geschalteten Photovoltaikzellen (im folgenden kurz Zellen genannt), von denen jede einzelne nach heutiger Technologie ca. 2,5 Watt liefert, d.h. die z.B. bei einer Spannung von 0,5 Volt einen Strom von 5 Ampere liefert. Beinhaltet ein Photovoltaikmodul z.B. 120 solcher Zellen, liegt an den Anschlusspolen des Moduls eine Gleich-Spannung von 60 Volt an. Sind z.B. acht dieser Module seriell zu einem Strang zusammengefasst, liegt zwischen den Enden des Strangs eine Spannung von ca. 480 Volt an.

Im Falle einer Löschaktion der Feuerwehr unter Zuhilfenahme von Löschwasser und/oder eines Löschschaum wird die Spannung über den Wasserstrahl an den Feuerwehrmann gebracht. Steht dieser mit nassen Gummistiefeln in einer Wasserpfütze, so weist er gegenüber Masse einen relativ kleinen Übergangswiderstand auf, und er wird einen Stromschlag von ca. 500 Volt erhalten, der fatale gesundheitliche Auswirkungen haben kann.

Die Erfindung hat es sich daher zur Aufgabe gestellt, einen Photovoltaikgenerator im Brandfall in einen für einen Löschenden, z.B. einen Feuerwehrmann, ungefährlichen Betriebszustand zu überführen.

Diese Aufgabe wird erfindungsgemäß durch einen Thermoschalter gelöst, der beim Ansprechen eine Reduzierung der Leistung des Photovoltaikgenerators bewirkt, wobei diese Reduzierung bis auf Null heruntergehen kann.

Eine Reduzierung der Leistung des Generators ist auf Grund des Aufbaus von Photovoltaikanlagen immer auch mit einer Reduzierung der Spannung an zumindest Teilen der Anlage verbunden. So kann der Thermoschalter am Modul selber, z.B. konstruktiv an seiner Rückseite, vorgesehen sein. Er kann aber auch einen gesamten Strang kurzschließen und damit spannungsfrei schalten, oder aber er kann die gesamte Anlage spannungsfrei schalten. Die Reduzierung der Spannung führt zu einem verringerten Gefährdungspotential.

Eine erste vorteilhafte grundlegende Ausführungsform bezieht sich somit auf einen Photovoltaikgenerator mit einer Vielzahl von in Reihe geschalteten Photovoltaikzellen, die gemeinsam ein Photovoltaikmodul bilden, bei dem an den Enden der Reihe zwei elektrische Modul-Anschlusspole vorhanden sind, und bei dem der Thermoschalter beim Ansprechen die Modul-Anschlusspole kurzschließt und somit eine Reduzierung der Leistung des Photovoltaikgenerators bewirkt.

Eine weitere vorteilhafte grundlegende Ausführungsform bezieht sich somit auf einen Photovoltaikgenerator mit einem Strang von elektrisch in Reihe verbundenen Photovoltaikmodulen, wobei an beiden Enden des Strangs jeweils ein elektrischer Strang-Anschlusspol vorgesehen ist, und wobei ein Thermoschalter beim Ansprechen die beiden Strang-Anschlusspole kurzschließt und somit eine Reduzierung der Leistung des Photovoltaikgenerators bewirkt.

Und eine dritte vorteilhafte grundlegende Ausführungsform bezieht sich somit auf einen Photovoltaikgenerator mit mehreren elektrisch parallel geschalteten Strängen von in Reihe geschalteten Photovoltaikmodulen sowie mit einem zu den Strängen parallel geschalteten Wechselrichter mit zwei Gleichstrom-Eingangsklemmen, wobei ein Thermoschalter beim Ansprechen die Gleichstrompole mit einander kurzschließt und somit eine Reduzierung der Leistung des Photovoltaikgenerators bewirkt.

Unter dem Begriff "Thermoschalter" wird hier jedes Schaltelement verstanden, welches bei Erreichen einer vorgebbaren oder vorgegebenen Temperatur oder eines anderen Feuer anzeigenden Parameters einen Schaltvorgang initiiert, der mittelbar oder unmittelbar zum Schließen oder Öffnen einer elektrischen Verbindung führt. Bei diesem Parameter kann es sich um das Auftreten von Rauch, um die Sichtbarkeit durch Luft hindurch, um die Ionisation von Luft, um den CO-Gehalt, etc. handeln. Dabei kann es sich um einen Thermoschalter mit einem mechanischen Wirkprinzip, wie z.B. um ein Bimetall-Element, handeln. Es kann sich aber auch um einen Thermoschalter mit einem elektrischen oder elektronischen Wirkprinzip, wie z.B. um einen Temperatursensor, an den eine Auswerteschaltung angeschlossen oder in diese eingebaut ist, handeln. Stattdessen kann auch ein Rauchdetektor (z.B. angeordnet auf der Rückseite des Moduls) oder ein Standard-Feuerdetektor an der Decke eines Raumes des betreffenden Gebäudes eingesetzt werden. Die Schaltoperation kann also durch ein irgendwo angeordnetes Feuer-DetektionsSystem als Sicherheitsmaßnahme ausgelöst werden.

Eine besonders vorteilhafte Ausführungsform der Erfindung sieht vor, den dem Photovoltaikmodul zugeordneten Thermoschalter in oder an der Anschlussdose des Moduls unter- bzw. anzubringen, die in der Regel ohnehin auf der Rückseite des Moduls vorhanden ist. Außerdem ist eine Integration in den Fertigungsprozess des Moduls zweckmäßig, um die Kosten der baustellenseitigen Montage niedrig zu halten.

Der Thermoschalter kann eine fest vorgegebene oder eine einstellbare Schalttemperatur aufweisen. Der erste Fall ist sinnvoll, wenn ein Thermoschalter direkt angeschlossen am einzelnen Modul, zur Anwendung kommt. Das Modul und seine maximale Leistung sind bekannt, woraus sich auch eine maximale Betriebstemperatur ergibt. Die Schalttemperatur wird dann geringfügig höher, z.B. in einem Bereich von 5° C bis 15° C höher, ausgelegt. Eine einstellbare Schalttemperatur ist dann in Betracht zu ziehen, wenn der Thermoschalter zwischen den Enden eines Strangs oder zwischen den Polen eines zugeordneten Wechselrichters angeordnet wird. Dann kann die dortige Temperatur bei maximaler Strang- oder Systemleistung ermittelt werden, und der Thermoschalter kann auf die für die individuelle Ausführung der Photovoltaikanlage zugeschnittene Schalttemperatur eingestellt werden. Die Schalttemperaturen liegen vorteilhafterweise in einem Bereich von 60° C bis 100° C, insbesondere zwischen 70° C und 90° C.

Es ist selbstverständlich, dass bei einer Anlage mehrere Thermoschalter mit unterschiedlicher Zuordnung eingesetzt werden können. Das heißt, dass die Module jeweils einen eigenen Thermoschalter besitzen können, und dass zusätzlich noch weitere Thermoschalter vorhanden sein können, die beim Ansprechen eine Leistungsreduzierung eines Strangs oder der Gesamtanlage bewirken.

Der einfachste Fall der Leistungsreduzierung ist dabei die Bildung eines Kurzschlusses zwischen den Polen der in Frage kommenden Komponenten, d.h. Modul, Strang, Gesamtanlage oder Wechselrichter.

Ausführungsbeispiele der Erfindung werden nun anhand von 3 Figuren näher erläutert. Es zeigen:
Fig. 1 einen Photovoltaikmodul, das mit einem Thermoschalter versehen ist,
Fig. 2 eine Vielzahl von Photovoltaikmodulen, die zu einem Strang in Reihe geschaltet sind, wobei dem Photovoltaikstrang ein Thermoschalter zugeordnet ist, und
Fig. 3 eine Vielzahl von Photovoltaiksträngen, die zu einer größeren Photovoltaikanlage parallel zu einander zusammengeschaltet sind, wobei der gesamten Photovoltaikanlage ein Thermoschalter zugeordnet ist.

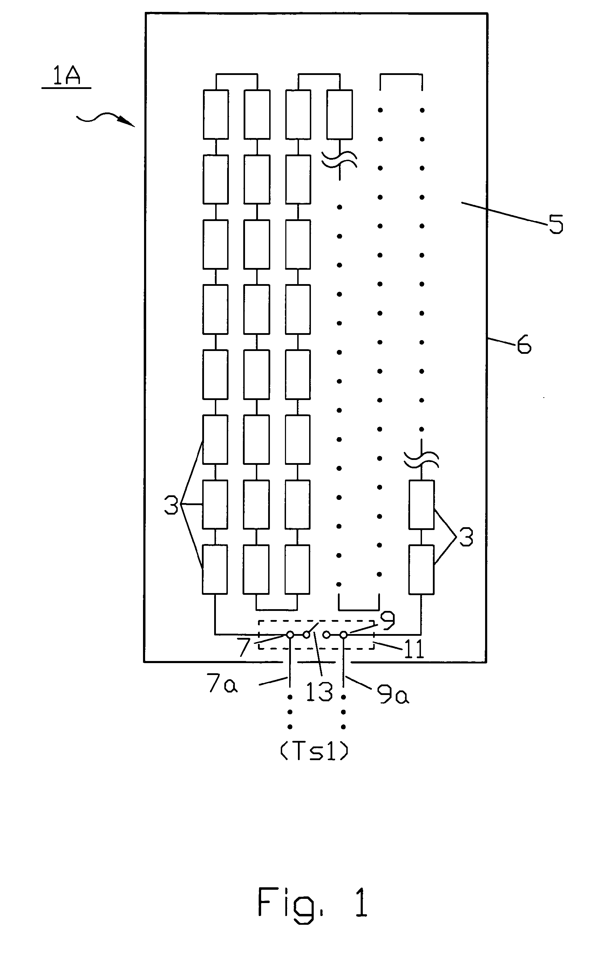

In Fig. 1 ist mit 1A ein besonders einfach aufgebauter Photovoltaikgenerator bezeichnet. Dieser umfasst hier eine Vielzahl von Photovoltaikzellen 3, die jeweils die kleinste Erzeugereinheit für die Umwandlung von Sonnenenergie in elektrischen Strom darstellen. Diese Vielzahl von Photovoltaikzellen 3, z.B. 120, ist miteinander in Reihe geschaltet und bildet ein Photovoltaikmodul 5. Das Modul 5 kann in einem Modulkasten 6 untergebracht sein. Die beiden Enden der Reihenschaltung sind die Anschlusspole 7, 9 des Moduls 5. Sie sind an oder in eine (gestichelt eingezeichnete) Anschlussdose 11, die sich z.B. seitwärts oder auf der Rückseite des Moduls 5 befindet, geführt. Die nach außen führenden Leitungen sind mit 7a, 9a bezeichnet. Zwischen den Anschlusspolen 7, 9 des Moduls 5 ist ein Thermoschalter 13 vorgesehen, der sich bei Überschreiten einer Grenz- oder Schalttemperatur Ts1 schließt. Abweichend von der Darstellung muss er nicht innerhalb oder an der Anschlussdose 11 angeordnet sein. Die hier gezeigte Anordnung ist jedoch besondern zweckmäßig. Der Thermoschalter 13 ruft beim Schließen einen Kurzschluss zwischen den Anschlusspolen 7, 9 hervor. Auf Grund diese Kurzschlusses bricht die Gleich-Spannung zwischen den Anschlusspolen 7 und 9 zusammen, und das Modul 5 wird im wesentlichen spannungsfrei. Im Falle eines Brandes tritt somit für eine löschende Person keine Gefahr auf.

Anzumerken wäre auch noch, dass der Thermoschalter 13 auch außerhalb des Modulkastens 6 angeordnet sein kann. Dies kann u. U. ein besonders schnelles Ansprechen bewirken.

Theoretisch wäre es auch denkbar, jeder Zelle 3 einen eigenen kleinen Thermoschalter 13 zuzuordnen, was denselben technisch gewünschten Effekt hätte. Dieses würde aber aus heutiger Sicht einen unwirtschaftlichen Aufwand bedeuten.

Als Thermoschalter 13 kann ein solcher auf mechanischer oder elektronischer Basis eingesetzt werden. Es kann sich also z.B. um ein Bimetall-Element handeln. Es kann sich aber auch um einen elektronischen Temperatursensor mit Auswerteschaltung handeln. Der Thermoschalter 13 sollte bereits bei der Produktion des Moduls 5 eingebaut werden.

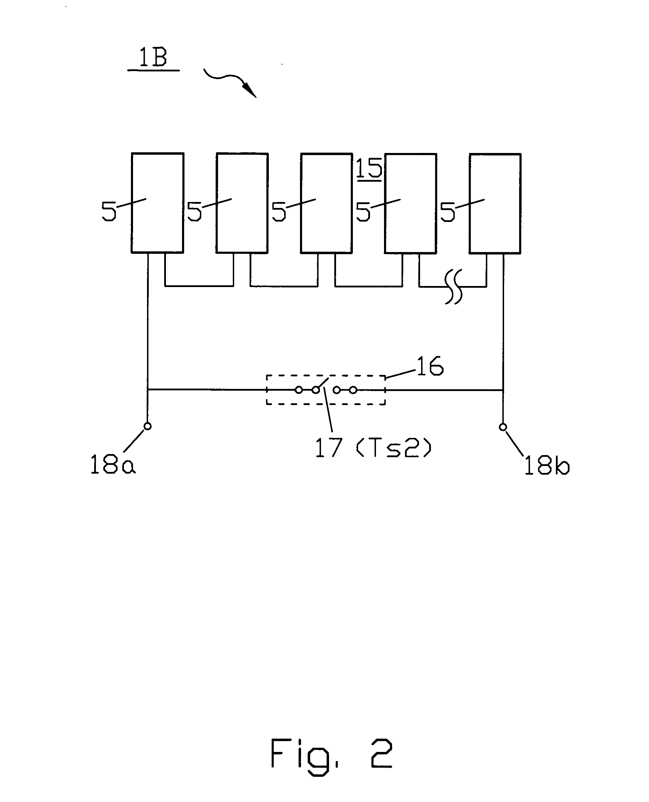

Gemäß dem Photovoltaikgenerator 1 B von Fig. 2 ist eine Anzahl der in Fig. 1 dargestellten Module 5 mit einander in Reihe geschaltet und damit zu einem Strang 15 zusammengefasst. Die Stranglänge kann sechs bis zehn Module 5 umfassen.

Zur gewünschten elektrischen Überbrückung im thermischen Gefahrenfall kann dieser Strang 15 mit einem Thermoschalter 17 versehen und überbrückt sein, der in oder an einer Anschlussdose 16 angeordnet ist. Dieser Thermoschalter 17 kann also zusätzlich zu den bei den einzelnen Modulen 5 angeordneten Modulschaltern 13 vorhanden sein. Bei Überschreiten einer vorgegebenen Grenz- oder Schalttemperatur Ts2 spricht dieser Thermoschalter 17 an. Er schließt dann die beiden Anschlusspole 18a, 18b kurz. Die Grenz- oder Schalttemperatur Ts2 dieses Thermoschalters 17 kann zu der Grenz- oder Schalttemperatur Ts1 des Modul-Thermoschalters 13 unterschiedlich sein.

Es soll hervorgehoben werden, dass in dem Photovoltaikgenerator 1 B gemäß Fig. 2 die einzelnen Module 5 aus Kostengründen auch jeweils ohne den jeweiligen Thermoschalter 13 eingesetzt sein können.

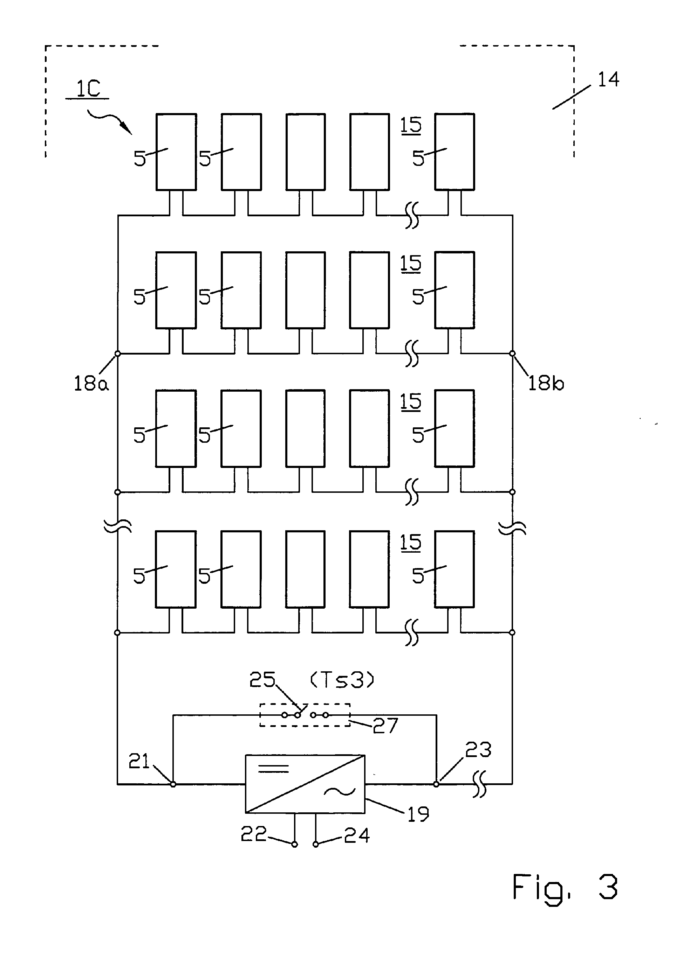

Bei dem Photovoltaikgenerator 1C gemäß Fig. 3 ist eine Anzahl der Stränge 15 parallel zu einander geschaltet und in einem (nur angedeuteten) Anlagenkasten 14 zu einer Photovoltaikanlage oder einem Anlagenabschnitt elektrisch zusammengefasst. Es ist zweckmäßig, den oder die einzelnen Strang-Thermoschalter 17 mit in den Anlagenkasten 14 einzubauen.

Analog soll hier hervorgehoben werden, dass in dem Photovoltaikgenerator 1C gemäß Fig. 3 die einzelnen Module 5 aus Kostengründen auch jeweils ohne den jeweiligen Thermoschalter 13 vorgesehen sein können.

Parallel zu den Strängen 15 ist ein Wechselrichter 19 geschaltet der die beiden Eingangsklammern 21, 23 besitzt. Mit anderen Worten: Die einzelnen Strangkästen der Stränge 15 sind elektrisch mit den Klemmen 21, 23 verbunden. Die Wechselspannungs-Ausgangsklemmen sind mit 22, 24 bezeichnet. Die Eingangsklemmen 21, 23 am Wechselrichter 19 können mittels eines weiteren Thermoschalters 25 kurzgeschlossen werden. Auch hier kann eine Anschlussdose 27 vorgesehen sein. Der Anlagen-Thermoschalter 25 wird bei Überschreiten einer vorgebbaren oder fest voreingestellten Grenz- oder Schalttemperatur Ts3 aktiviert. Beim Erreichen dieser Grenz- oder Schalttemperatur Ts3, was bei Auftreten eines Brandes geschieht, wird die unter Umständen recht hohe Ausgangsspannung, die an den Klemmen 21, 23 anliegt, zurückgenommen oder bis auf Null reduziert. Dadurch wird eine Unfallgefahr für eine Person, die z.B. zwecks Löschens eines Brandes sich der Anlage 1C nähert, drastisch reduziert oder völlig vermieden.

Die eingestellte oder vorgegebene Schalttemperatur Ts1, Ts2, Ts3 kann jeweils im Bereich von 60° C bis 100° C, bevorzugt zwischen 70° C und 90° C, liegen. Durch diese Wahl oder Einstellung wird das Auftreten eines Brandes mit Sicherheit erfasst, so dass das Abschalten als Sicherheitsmaßnahme eingeleitet werden kann.

### Bezugzeichenliste

- 1A, 1B, 1C: Photovoltaikgenerator
- 3: Photovoltaikzelle
- 5: Photovoltaikmodul
- 6: Modulkasten
- 7, 9: Anschlusspole des Moduls 5
- 7a, 9a: Abgangsleitungen des Moduls 5
- 11: Anschlussdose
- 13: Thermoschalter des Moduls 5
- 14: Anlagenkasten
- 15: Strang
- 16: Anschlussdose
- 17: Thermoschalter des Strangs 15
- 18a, 18b: Anschlusspole des Strangs 15
- 19: Wechselrichter
- 21, 23: Eingangsklemmen des Wechselrichters 19
- 22, 24: Wechselspannungs-Ausgangsklemmen
- 25: Thermoschalter am Wechselrichter 19
- 27: Anschlussdose

- Ts1: Grenz-, Ansprech- oder Schalttemperatur des Thermoschalters 13
- Ts2: Grenz-, Ansprech- oder Schalttemperatur des Thermoschalters 15
- Ts3: Grenz-, Ansprech- oder Schalttemperatur des Thermoschalters 25

## Patentansprüche

1. Photovottaikgenerator (1A, 1 B, 1 C), **gekennzeichnet durch** einen Thermoschalter (13, 17, 25), der beim Ansprechen eine Reduzierung der Leistung des Photovoltaikgenerators (1A, 1 B, 1 C) bewirkt oder diese auf Null setzt.

2. Photovoltaikgenerator (1 A, 1 B, 1 C) nach Anspruch 1 mit einer Vielzahl von in Reihe geschalteten Photovoltaikzellen (3), die gemeinsam ein Photovoltaikmodul (5) bilden, bei dem an den Enden der Reihe zwei elektrische Modul-Anschlusspole (7, 9) vorhanden sind, und bei dem der Thermoschalter (13) beim Ansprechen die Modul-Anschlusspole (7, 9) kurzschließt und somit eine Reduzierung der Leistung des Photovoltaikgenerators (1A, 1 B, 1 C) bewirkt.

3. Photovoltaikgenerator (1A, 1 B, 1 C) nach Anspruch 1 oder 2 mit einem Strang (15) von elektrisch in Reihe verbundenen Photovoltaikmodulen (5), wobei an beiden Enden des Strangs (15) jeweils ein elektrischer Strang-Anschlusspol (18a, 18b) vorgesehen ist, und wobei ein Thermoschalter (17) beim Ansprechen die beiden Strang-Anschlusspole (18a, 18b) kurzschließt und somit eine Reduzierung der Leistung des Photovoltaikgenerators (1 B, 1 C) bewirkt.

4. Photovoltaikgenerator (1 C) nach Anspruch 1, 2 oder 3 mit mehreren elektrisch parallel geschalteten Strängen (15) von in Reihe geschalteten Photovoltaikmodulen (5) sowie mit einem zu den Strängen (15) parallel geschalteten Wechselrichter (19) mit zwei Gleichstrom-Eingangsklemmen (21, 23), wobei ein Thermoschalter (25) beim Ansprechen die Gleichstrompole (21, 23) mit einander kurzschließt und somit eine Reduzierung der Leistung des Photovoltaikgenerators (1 C) bewirkt.

5. Photovoltaikgenerator nach einem der Ansprüche 1 bis 4, wobei das Photovoltaikmodul (5) mit einer Anschlussdose (11) versehen ist, und wobei der dem Photovoltaikmodul (5) zugeordnete Thermoschalter (13) in oder an der Anschlussdose (11) angeordnet ist.

6. Photovoltaikgenerator nach Anspruch 5, **dadurch gekennzeichnet, dass** der Einbau des Thermoschalters (13) fertigungsseitig bei der Produktion des Photovoltaikmoduls (5) oder der Anschlussdose (11) erfolgt ist.

7. Photovoltaikgenerator nach einem der Ansprüche 3 bis 6, wobei der Strang (15) mit einem Anschlusskasten (16) versehen ist, und wobei der dem Strang (15) zugeordnete Thermoschalter (17) in oder an dem Anschlusskasten (16) angeordnet ist.

8. Photovoltaikgenerator nach einem der Ansprüche 1 bis 7, **dadurch gekennzeichnet, dass** dem Thermoschalter (13, 17, 25) ein mechanisches Wirkprinzip zugrunde liegt, wie z.B. ein Bimetall-Element.

9. Photovoltaikgenerator nach einem der Ansprüche 1 bis 7, **dadurch gekennzeichnet, dass** dem Thermoschalter (13, 17, 25) ein elektrisches Wirkprinzip zugrunde liegt, wie z.B. ein Temperatursensor mit Auswerteschaltung.

10. Photovoltaikgenerator nach einem der Ansprüche 1 bis 9, **dadurch gekennzeichnet, dass** der Thermoschalter (13, 17, 25) bei einer Schalttemperatur (Ts1, Ts2, Ts3) zwischen 70° C und 90° C schaltet.
